# EUROPEAN PATENT APPLICATION

(11) **EP 1 491 653 A2**
(43) Date of publication of application: **29.12.2004**
(21) Application number: 04013612.9
(22) Date of filing: 09.06.2004
(51) Int. Cl.: C23C 14/04, C23C 14/24

(54) **Evaporative deposition methods and apparatus**

(30) Priority: 13.06.2003 JP 2003169177; 13.06.2003 JP 2003169426
(71) Applicant: Pioneer Corporation, Meguro-ku, Tokyo (JP)
(72) Inventor: Hirano, Shizuo Pioneer corp., Tsurugashima-shi Saitama 350-2288 (JP)
(74) Representative: Manitz, Finsterwald & Partner GbR

(57) **Abstract**

In evaporative deposition method, vaporized deposition material is supplied to a nozzle and is held by the nozzle because of temperature decrease thereof. Then, the deposition material is vaporized by heating the nozzle, thereby forming a thin film of the material on a substrate. A evaporative deposition apparatus includes a nozzle for holding deposition material. The apparatus also includes a temperature adjuster for heating and cooling the nozzle and a supplier, communicating with the nozzle, for supplying the vaporized deposition material to the nozzle. A method for forming a pattern of deposition material includes: preparing an evaporative deposition-material plate including a thin film of deposition material formed on one principal surface of a light-transmitting plate; moving the evaporative deposition-material plate within a plane parallel to a substrate; and irradiating the evaporative deposition-material plate with a laser beam incident on the other principal surface of the plate.

## Description

### BACKGROUND OF THE INVENTION

### 1. Field of the Invention

The present invention relates to an evaporative deposition method, an evaporative deposition head and a method for forming a pattern of deposition materials, more particularly, to an evaporative deposition-material disk used for such pattern forming method. Moreover, the present invention relates a fabrication method and a fabrication apparatus for fabricating an organic electroluminescence display panel that includes a plurality of organic electroluminescence devices each of which has at least one organic layer containing a light emitting layer and is interposed between a pair of electrodes under the utilization of such pattern forming method.

### 2. Description of the Related Art

An organic electroluminescence device uses an organic compound that exhibits electroluminescence (hereinafter, simply referred to as EL) , i.e., that emits light when a current flows therethrough. Such an organic compound may be called as organic EL material. For example, the organic EL device is formed by sequentially forming a transparent electrode serving as an anode, one or more organic layers containing a light emitting layer formed of the organic EL material, and a metal electrode serving as a cathode on a transparent substrate in that order. A plurality of organic EL devices formed on the substrate in a predetermined pattern constitutes an organic EL display panel. For the organic layer structure of the organic EL device, there are a single layer structure of a light emitting layer, a three-layer structure (including an organic hole transport layer, a light emitting layer, and an organic electron transport layer) , a two-layer structure (including an organic hole transport layer and a light emitting layer), and a multi-layer structure (in which an electron or hole injection layer is added between the layers of any of the above-listed structures).

The organic EL display panel of a matrix type, for example, includes column electrodes containing a transparent conductive layer, an organic layer, and row electrodes containing a metal electrode layer that are sequentially formed in that order. The column electrodes and the row electrodes intersect with each other. The column electrodes are formed as strip electrodes arranged in parallel to each other with a predetermined space therebetween. The row electrodes are also formed in a similar manner. Thus, a plurality of organic EL devices (light emitting pixels) are formed at intersections of the column electrodes and the row electrodes, respectively, and those organic EL devices arranged in a matrix form a display region of the organic EL display panel. Such an organic EL display panel can display an image by driving one or more of the organic EL devices that are arranged on the transparent substrate in a matrix and are appropriately connected, with predetermined signals. Moreover, by forming the display region including organic EL devices, each of which emits light of any of three primary colors, red (R), green (G), and blue (B), a full-color display apparatus can be achieved.

In fabrication of the above organic EL display panel, the organic layer is formed by deposition because it is not suitable for a wet process.

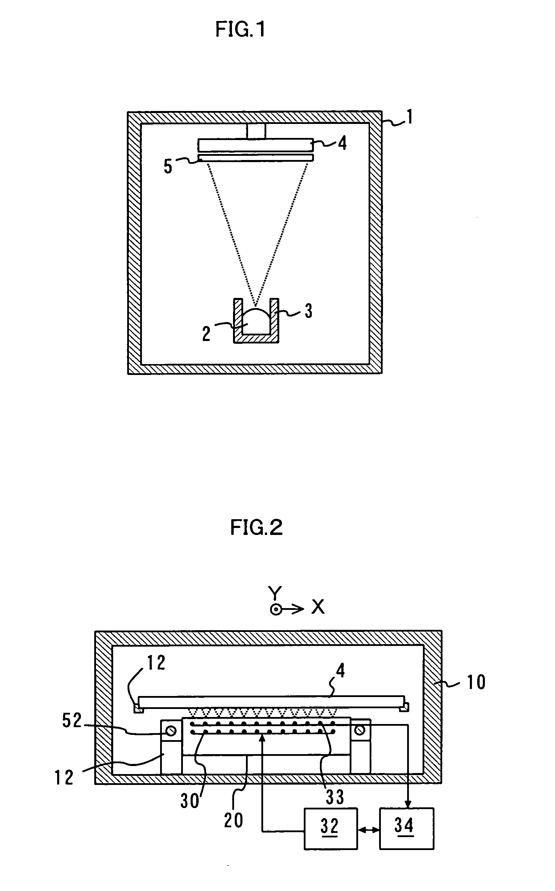

A conventional resistance heating evaporative deposition method using a point evaporative deposition source and a metal mask is described referring to Fig. 1. According to this method, as shown in Fig. 1, deposition material 2 such as organic material or electrode material is contained and heated in a boat 3 in an evaporative deposition chamber 1 of a vacuum evaporative deposition apparatus. Then, the material that is sublimed is deposited on a glass substrate 4 in a predetermined pattern through a metal mask 5 that is arranged above the boat 3 to be apart away from the boat 3. In this manner, a layer of the organic material or electrode material is selectively formed by evaporative deposition. This method is advantageous in that formation of the organic material layer and the patterning thereof can be performed simultaneously. However, this method also has problems. For example, production of the metal mask and positioning of the metal mask with respect to the substrate are difficult. In addition, the efficiency in use of the material is significantly low. Moreover, in a case of pattern formation on a large transparent substrate by the above evaporative deposition method, a large mask is required. However, there are serious problems of deformation of the large mask, reduction of precision of pattern formation caused by expansion of the large mask, and the like.

Furthermore, the deposition material also adheres to a wall surface of the chamber and the metal mask. Therefore, the efficiency in use of the material is 3-5%. Such low efficiency makes a large contribution to the increase of the cost. In order to prevent the above problems, methods using no mask, or so-called maskless methods have been proposed.

For example, a method has been proposed in which an electrode pattern is formed on a transfer plate, the deposition material is applied onto that transfer plate, and a current is caused to flow through the electrode pattern. Thus, the deposition material in the electrode pattern is transferred. See Japanese Patent Laid-Open Publication No. 2002-302759. Another method has been proposed in Japanese Patent Laid-Open Publication No. 2002-110350 in which pattern formation is achieved by bringing a substrate on which the pattern is to be formed into contact with an evaporative deposition-material plate and continuously scanning the substrate and the evaporative deposition-material plate with a laser beam by using a galvanometer and an fθ lens.

### SUMMARY OF THE INVENTION

However, the former method has a problem in that pre-processing for the transfer plate is added, which results in the increase of the cost. The former method also has a problem of low efficiency in use of the deposition material because of the deposition material remaining in a region other than the transfer pattern, and a problem of long deposition time. According to the latter method, since the substrate and the evaporative deposition-material plate are arranged one for one, a larger evaporative deposition apparatus is required for fabricating a larger evaporative deposition-material plate in a case where the size of the substrate becomes larger. This leads directly to the increase of equipment cost. Moreover, when the deposition material is transferred from the evaporative deposition-material plate to the substrate, the evaporative deposition-material plate and the substrate are moved together on a translation stage from one end to the opposite end. Thus, the size of the vacuum chamber has to be twice or more the substrate. This inevitably increases the size of the evaporative deposition apparatus.

Therefore, one object of the present invention is to provide a method for forming a pattern of deposition material, an evaporative deposition-material disk used in that method, and a fabrication apparatus and a fabrication method of an organic EL display panel, which can achieve the evaporative deposition using no mask so as to eliminate various problems in a case of using the mask, can largely improve the efficiency in use of the material, and can prevent the aforementioned problems in the two maskless methods, of the complicated pre-processing of the transfer plate and the size increase.

A evaporative deposition method according to the present invention comprises the steps of:
supplying a vaporized deposition material to a nozzle;
holding the deposition material at the nozzle by lowering a temperature thereof; and
vaporizing the deposition material by heating the nozzle to eject a secondary vaporized deposition material from the nozzle to form a thin film of the deposition material on a substrate arranged to be opposed to the nozzle.

A evaporative deposition head according to the present invention comprises:
a nozzle for holding a deposition material, the nozzle having an opening through which the deposition material to be vaporized is ejected;
a temperature adjuster for heating and cooling the nozzle; and
a supplier, communicating with the nozzle, for supplying the deposition material to be vaporized to the nozzle.

According to the present invention, a fabrication apparatus for producing an organic electroluminescence display panel which includes a plurality of organic electroluminescence devices arranged on a substrate, each of organic electroluminescence devices having at least one organic layer that is sandwiched between a pair of electrodes and contains a light emitting layer, the fabrication apparatus comprises:
an evaporative deposition head including
   a plurality of nozzles for holding a deposition material for the organic electroluminescence devices,
   a temperature adjuster for heating and cooling the nozzles, and
   a supplier, communicating with the nozzles, for supplying the deposition material to be vaporized to the nozzles, the nozzles having openings through which the deposition material to be vaporized is ejected; and
a supporting mechanism for supporting the evaporative deposition head in such a manner that the openings of the nozzles are opposed to the substrate with a space therebetween.

A method for forming a pattern of deposition material according to the present invention comprises the steps of:
preparing an evaporative deposition-material plate including a light-transmitting plate and a thin film of the deposition material formed on one principal surface of the light-transmitting plate; moving the evaporative deposition-material plate within a plane parallel to a substrate that is arranged to be opposed to the thin film with a space therebetween; and
irradiating the light-transmitting plate with a laser beam from the other principal surface of the light-transmitting plate, to vaporize and eject the deposition material to deposit the vaporized deposition material on the substrate.

A evaporative deposition-material disk according to the present invention comprises a light-transmitting plate; and a thin film of a deposition material formed on one principal surface of the light-transmitting plate, wherein the evaporative deposition-material disk is irradiated with a laser beam incident on the other principal surface of the light-transmitting plate.

According to the present invention, a fabrication apparatus of an organic electroluminescence display panel including a plurality of organic electroluminescence devices each having at least one organic layer that is sandwiched between a pair of electrodes and contains a light emitting layer, the fabrication apparatus comprises:
a laser-beam emitting device for emitting a laser beam;
an evaporative deposition-material disk including a light-transmitting plate, a thin film of a deposition material formed on one principal surface of the light-transmitting plate, the evaporative deposition-material disk being irradiated with the laser beam incident on another surface of the light-transmitting plate; and
a supporting mechanism for supporting the evaporative deposition-material disk in such a manner that the thin film is apart from a substrate and is opposed to the substrate, and to rotate the evaporative deposition-material disk around a central axis of the evaporative deposition-material disk within a plane parallel to the substrate.

According to the present invention, a fabrication method of an organic electroluminescence display panel including a plurality of organic electroluminescence devices each having at least one organic layer that is sandwiched between a pair of electrodes and contains a light emitting layer, the fabrication method comprises:
a first step of fixedly arranging a substrate on which a pattern is to be formed;
a second step of arranging an evaporative deposition-material disk including a light-transmitting plate and a thin film of a deposition material formed on one principal surface of the light-transmitting plate in such a manner that the thin film is apart from the substrate and is opposed to the substrate, and rotating the evaporative deposition-material disk around a central axis of the evaporative deposition-material disk within a plane parallel to the substrate;
a third step of irradiating the other principal surface of the evaporative deposition-material disk with a laser beam to form a laser spot and positioning the laser spot on the thin film; and
a fourth step of positioning the evaporative deposition-material disk with respect to the substrate, wherein the deposition material is deposited on the substrate by vaporizing the deposition material.

### BRIEF DESCRIPTION OF THE DRAWINGS

Fig. 1 is a cross-sectional view schematically showing a conventional evaporative deposition method;
Fig. 2 is a cross-sectional view schematically showing a fabrication apparatus of an organic EL display panel according to an embodiment of the present invention;
Fig. 3 is a perspective view schematically showing an evaporative deposition head according to the embodiment of the present invention;
Fig. 4 is a partial plan view of a driving portion of the fabrication apparatus of an organic EL display panel according to the embodiment of the present invention;
Fig. 5 is a cross-sectional view schematically showing the evaporative deposition head according to the embodiment of the present invention;
Fig. 6 is a partial cross-sectional view showing a region near a nozzle of the evaporative deposition head according to the embodiment of the present invention;
Fig. 7 is a partial plan view of the region near the nozzle of the evaporative deposition head according to the embodiment of the present invention;
Fig. 8 is a cross-sectional view schematically showing an operation of the evaporative deposition head according to the embodiment of the present invention;
Fig. 9 is a partial plan view schematically showing an exemplary arrangement of light emitting pixels on a full-color organic EL display panel;
Fig. 10 is a plan view showing an evaporative deposition head according to another embodiment of the present invention;
Fig. 11 is a partial perspective view of a region near a nozzle of the evaporative deposition head according to still another embodiment of the present invention;
Fig. 12 is a partial cross-sectional view of the region near the nozzle of the evaporative deposition head according to still another embodiment of the present invention;
Fig. 13 is a cross-sectional view schematically showing a main part of a fabrication apparatus of an organic EL display panel according to the embodiment of the present invention;
Fig. 14 is a cross-sectional view schematically showing the fabrication apparatus of an organic EL display panel according to the embodiment of the present invention;
Fig. 15 is a partial plan view of the fabrication apparatus according to the embodiment of the present invention;
Fig. 16 is a cross-sectional view schematically showing an evaporative deposition-material disk and a substrate in a method for forming a pattern of deposition material, according to another embodiment of the present invention;
Fig. 17 is a plan view schematically showing an exemplary arrangement of light emitting pixels on a full-color organic EL display panel; and
Fig. 18 is a cross-sectional view schematically showing an evaporative deposition-material plate and a substrate in a method for forming a pattern of deposition material, according to still another embodiment of the present invention.

### DETAILED DESCRIPTION OF THE INVENTION

In general resistance heating evaporative deposition, a deposition material that was heated and sublimed jumps from a boat toward various directions straightly, so as to adhere to a sidewall of an evaporative deposition chamber or a metal mask that is below a sublimation temperature. However, the deposition material that adhered to something jumps again when being heated to the sublimation temperature or higher. The inventor of the present application focuses attention on such a behavior of the deposition material. Thus, the principle of the present invention positively uses a phenomenon that the deposition material adheres to an object below the sublimation temperature. Controlling the temperature of the object can perform the re-sublimation of the deposition material.

In the evaporative deposition using no mask, a point evaporative deposition source is configured in form of spot having a diameter of several microns and a plurality of such point evaporative deposition sources, i . e . , nozzles of fine holes are provided. By ejecting the deposition material from those point evaporative deposition sources, a necessary distance for the evaporative deposition can be largely reduced. The need of the metal mask can be eliminated.

Even if the nozzles of fine holes are provided, the multiple nozzles have to be opened and closed in order to form the pattern of the deposition material. According to the present invention, fine holes each having a diameter of 10 microns or less are opened and closed by controlling a temperature of the nozzles.

Preferred embodiments of the present invention are described with reference to the drawings.

Fig. 2 shows an exemplary fabrication apparatus of an organic EL display panel according to the present invention.

As shown in Fig. 2, a substrate 4 for a display panel (transparent substrate formed of glass or resin, for example) and an evaporative deposition head 20 are arranged in parallel to each other with a space therebetween by associated supporting mechanisms 12, respectively. The substrate 4 and the evaporative deposition head 20 are apart from each other in an evaporative deposition chamber 10 of the fabrication apparatus that has a reduced pressure therein. The supporting mechanism 12 is provided with feed screws 52 of a translation driving device that can relatively move the evaporative deposition head 20 and the substrate 4 in parallel with respect to each other.

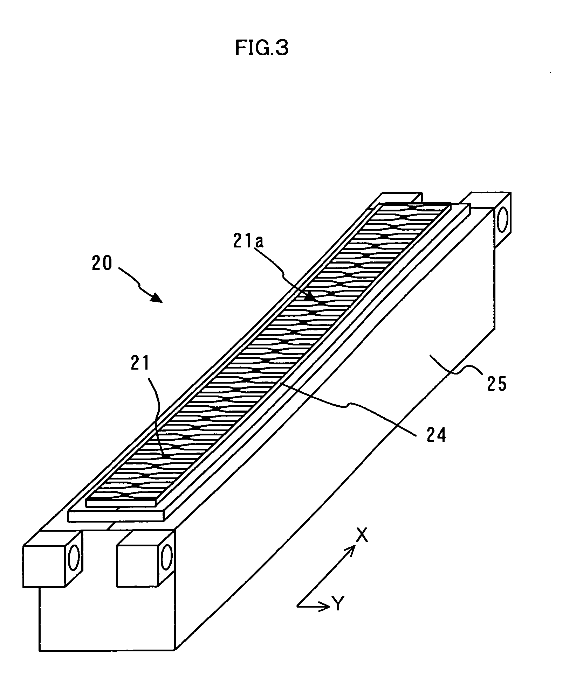

As shown in Fig. 3, the evaporative deposition head 20 includes a nozzle plate 24 and a supplying container 25. The nozzle plate 24 is provided with nozzles 21 each having a fine opening to eject the vaporized deposition material and heating elements as a part of a temperature adjuster for heating and cooling those nozzles 21. The supplying container 25 is a supplier that communicates with the nozzles 21 and supplies the vaporized deposition material to the nozzles 21. The evaporative deposition head 20 may be a one-dimensional evaporative deposition head including a nozzle array 21a of a plurality of nozzles 21 arranged one-dimensionally in the longitudinal direction X. The nozzle plate 24 has a width smaller than the width of a display region of a plurality of organic EL devices to be formed on the substrate 4 and extends over a part of the display region. The area of the nozzle plate 24 is smaller than the area of the display region. The evaporative deposition head 20 scans the substrate 4 along a direction perpendicular to the longitudinal direction X of the evaporative deposition head 20.

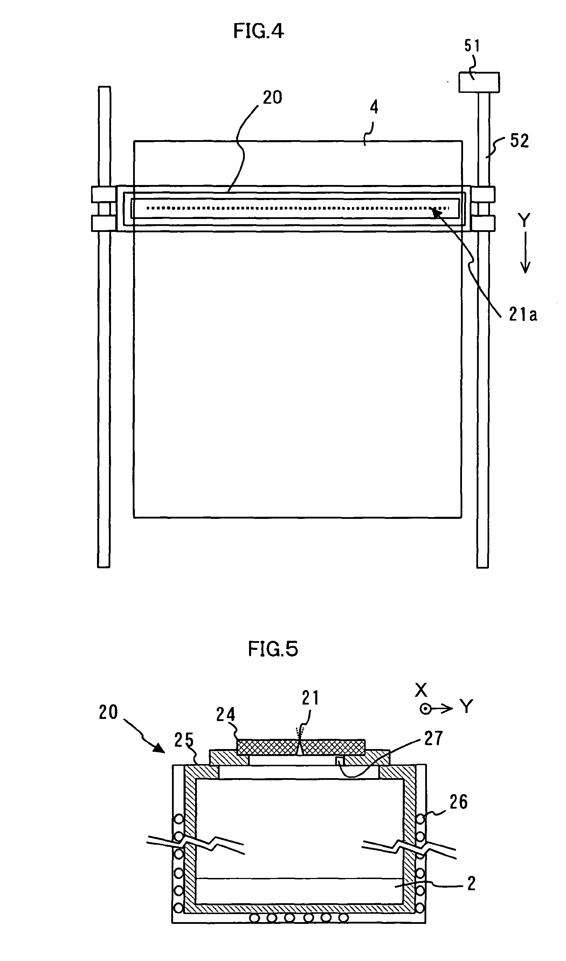

As shown in Fig. 4, the evaporative deposition head 20 includes a translation driving device that allows intermittent translation of the evaporative deposition head 20 in a predetermined direction with respect to the substrate 4. More specifically, an external feed screw 52 that is rotated by an external motor 51 is provided in parallel to the substrate 4. The chassis of the evaporative deposition head 20 and the feed screw 52 are screwed together. The external motor 51 is connected to a motor driving circuit (not shown) and is controlled by that motor driving circuit to perform a predetermined operation.

As shown in Fig. 4, when the one-dimensional evaporative deposition head 20 is standstill at a certain position and the nozzle is heated by the heating element 30 corresponding to a desired pixel, then stuffed organic material is sublimed so as to be deposited to a desired location on the substrate 4. Then, as shown in Fig. 4, one of the substrate 4 and the evaporative deposition head 20 is relatively moved with respect to the other in the direction Y, and is then stopped in order to perform the evaporative deposition of the organic material in the above-mentioned manner. By repeating such relative translation and the evaporative deposition, a plurality of pixels are formed in a desired pattern on the entire surface of the substrate 4.

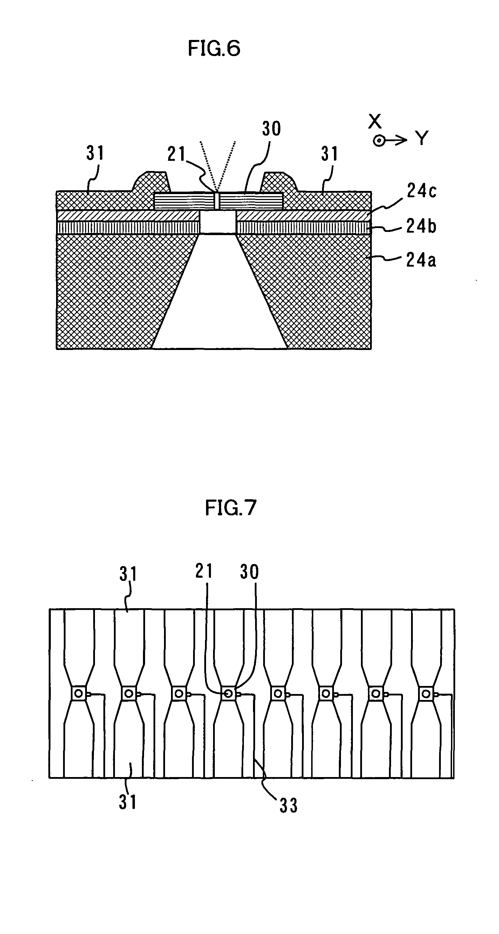

As shown in Fig. 5, the supplying container 25 of the evaporative deposition head 20 is provided with a heater 26 for heating the circumference of the supplying container 25 of the evaporative deposition head 20 and keeping it warm, and a temperature sensor 27 for monitoring the internal temperature. The temperature control for the entire supplying container 25 is performed by the use of the heater 26 and the temperature sensor 27. The nozzle plate 24 in which the nozzles 21 having fine openings are formed is attached to the top of the supplying container 25 so as to close an opening of the supplying container 25 which extends in the longitudinal direction.

Fig. 6 shows a region near the nozzle of the evaporative deposition head. The nozzle plate 24 includes a main body 24a made of thermal conduction material, and a thermal insulation layer 24b made of thermal insulation material and an electrical insulation film 24c that formed on the top surface of the main body 24a substantially entirely in that order. On the electrical insulation film 24c are formed the heating elements 30. As shown in Fig. 7, a pair of electrodes 31 are formed on the electrical insulation film 24c to sandwich the corresponding heating element 30, which are connected to the corresponding heating element 30 and supply a current to it. In each heating element 30, the nozzle 21 that is a fine hole is provided at the center. The nozzle 21 has a length and a hole-diameter that are required for forming a desired deposition pattern. The diameter and length of the nozzle 21 are determined by material, area, and thickness of the deposition pattern to be formed. The heating element 30 is formed of material that efficiently generates Joule heat when a current flows therethrough.

Next, an operation of the evaporative deposition head 20 is described.

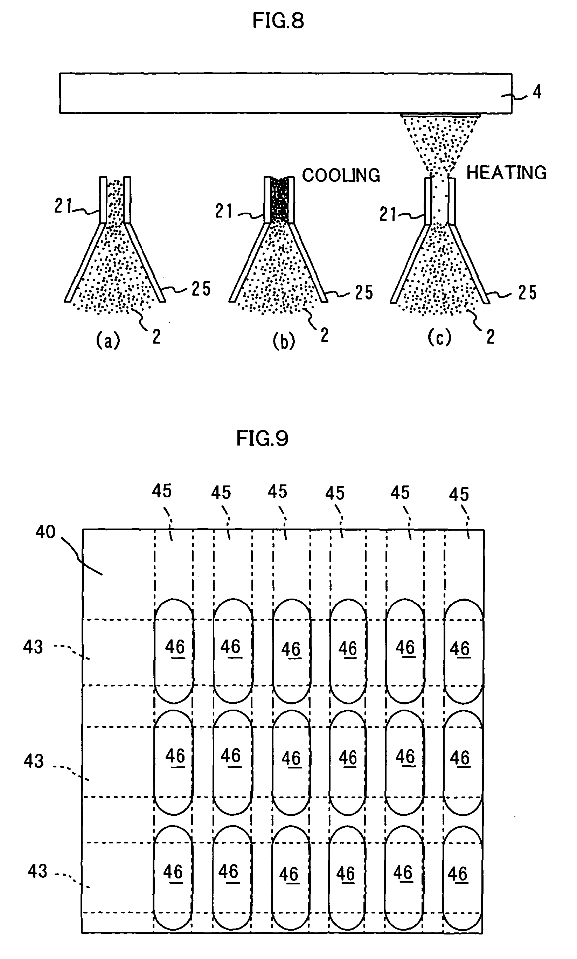

As shown in Fig. 8, the supplying container 25 is placed in such a manner that the nozzle 21 comes close to the substrate 4 to which the nozzle 21 is opposed. The supplying container 25 is then heated so as to sublime deposition material accommodated therein, thereby filling the supplying container 25 with the vaporized deposition material 2 (Fig. 8(a)). While no current flows through the heating element, the temperature of the nozzle 21 is at or below the sublimation point of the deposition material because the nozzle 21 was cooled down naturally. Thus, the nozzle 21 in this state holds the deposition material while being clogged with the deposition material. Therefore, the vaporized deposition material in the supplying container 25 cannot jet out (Fig. 8(b)). While a current flows from the electrode to the heating element, the nozzle 21 provided in the heating element generates heat because of Joule heat and increases its temperature to the sublimation point of the deposition material or higher. Thus, the deposition material that clogged the nozzle 21 is sublimed and jets out toward the substrate opposed to the nozzle 21 at a substantially constant angle together with the deposition material that fills the inside of the supplying container (Fig. 8(c)). If the substrate for display panel is placed near the top of the nozzle 21 while the deposition material is jet out, a deposition pattern is formed on that substrate. While no current flows through the heating element, the heat generation of the heating element is stopped. Thus, the nozzle is cooled down naturally in a moment, to the sublimation temperature of the deposition material or lower. Therefore, the fine hole of the nozzle 21 is clogged with the deposition material (Fig. 8(b)), preventing the deposition material in the supplying container 25 from jetting out. In this manner, formation and patterning of the deposition pattern can be performed simultaneously by selectively allowing a current to flow between the electrodes. Although the nozzle is cooled down naturally in the above example, cooling may be achieved by forced cooling using a Peltier device, for example.

In order to supply an electric power to the heating element and heat it, the organic EL display panel fabrication apparatus includes a power supply 32 that selectively supplies an electric power to the electrodes connected to the heating elements 30 of the evaporative deposition head 20, as shown in Fig. 2. That fabrication apparatus also includes second temperature sensors 33 and a temperature controller 34. The second temperature sensors are connected to the heating elements 30, respectively, each of which detects the temperatures of the corresponding heating elements 30. The temperature controller 34 is connected to the power supply 32 and controls the temperature of each heating element in accordance with the detected temperature. In a case where a plurality of heating elements are provided, for example, the temperature controller 34 may control the temperatures of the heating elements 30 individually so as to make those temperatures different from each other. Although the second temperature sensor 33 is provided for each heating element in the shown example, a single second temperature sensor 33 may monitor the temperature of the heating elements in a case where the heating elements are turned on and off simultaneously so as to have the same temperature.

As described above, according to the present invention, it is possible to form a thin film of the deposition material by the evaporative deposition and pattern that thin film simultaneously, without a metal mask. Therefore, a precise metal mask that is difficult to produce is not required, reducing the fabrication cost. In addition, the efficiency in the use of the deposition material, that was as low as 3-5% conventionally, can be dramatically increased to 50% or more.

Moreover, according to the present invention, multiple-spot evaporative deposition is performed. Thus, the distance between the source of the deposition material and the substrate for display panel can be largely reduced. Therefore, it is possible to reduce the size of the evaporative deposition apparatus itself, largely reducing the cost of equipment and running cost. Furthermore, unlike the thermal transfer method, it is not necessary to prepare a separate transfer film. Therefore, the present invention is more advantageous than the thermal transfer method in the cost because the present invention does not require equipment and processes for handling the transfer film.

According to the present invention, the deposition material that was supplied to fine holes while being vaporized is held by the fine holes. Then, the deposition material is sublimed to jet out directly to a substrate for display panel that is arranged to be opposed to the fine holes. Thus, the directivity of the deposition material can be made stable and a width of a pattern formed on the substrate can be also made stable, resulting in formation of the pattern having a clear profile. Moreover, since the fine-hole nozzle provided in the heating element is used, a quick response to switching of the current between the on-state and the off-state can be obtained. Therefore, it is easy to control the ejected amount of the deposition material and the thickness of the resultant thin film of the deposition material on the substrate. In addition, since the time required for the pattern formation can be reduced, production tact-time can be reduced.

Fig. 9 is a partial plan view of an organic EL display panel 40 having an arrangement of an organic layer 46 containing a layer of tris(8-quinolinolato) aluminum, that is one of light emitting organic compounds, for example, deposited by the organic EL display panel fabrication apparatus, seen from a transparent-substrate side. For example, the organic layer includes a light emitting layer only, or a hole transport layer, an electron transport layer or an electron injection layer or a hole injection layer in addition to the light emitting layer. On a transparent substrate 4 of the organic EL display panel 40, transparent electrodes 43 formed of indium tin oxide, for example, are deposited in stripes prior to formation of the organic layer 46. The transparent electrodes 43 are arranged in parallel to each other. On the transparent electrodes 43, organic material that was caused to sublime so as to jet out from the nozzles of the present invention respectively corresponding to a plurality of pixels in each row is deposited, thereby forming a pattern. Then, on the organic material, metal electrodes 45 that intersect with the transparent electrodes 43 are provided in stripes. Thus, light-emitting portions 46 (organic EL devices) are arranged on the glass substrate 4 in a matrix. The organic EL display panel 40 can display a full-color image by red (R) light-emitting portions, green (G) light-emitting portions, and blue (B) light-emitting portions that are arranged in such a manner that each of three colors is arranged at a predetermined pitch.

In the above example, a simple matrix organic EL display panel has been described. Alternatively, the present invention can be applied to fabrication of an active matrix organic EL display panel, which uses a substrate on which active devices such as TFTs, to be respectively connected to a plurality of organic EL devices, are formed prior to formation of the organic EL devices.

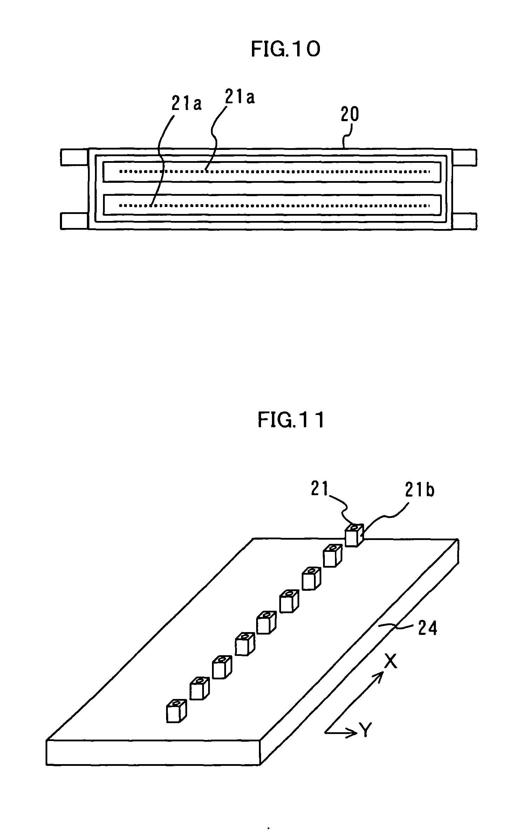

Fig. 10 is a plan view of a two-dimensional evaporative deposition head 20 in which a plurality of nozzles are arranged two-dimensionally, for example, by arranging two nozzle arrays 21a each including nozzles arranged in one dimension, in parallel. By using such a two-dimensional evaporative deposition head 20, evaporative deposition can be performed easily and efficiently in a short time.

Fig. 11 shows a region near a nozzle of the evaporative deposition head as another embodiment of the present invention. Light receiving portions 21b of laser beam are provided to the respective nozzles 21 as a protruding portion for the nozzles in the evaporative deposition head.

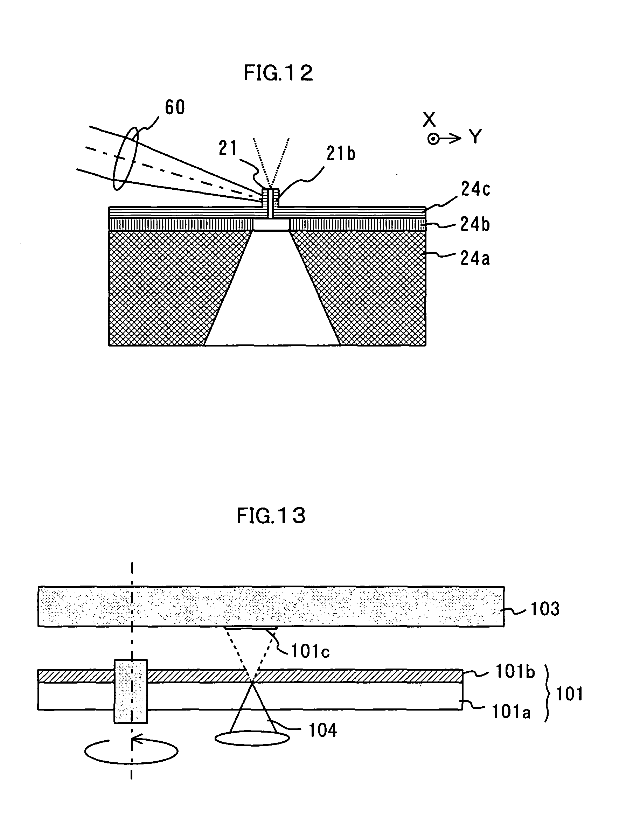

As shown Fig. 11, the embodiment of evaporative deposition head may have another temperature adjuster which includes a laser-beam emitting device 60 and the light receiving portion 21b, instead of the temperature adjuster (including the heating elements contacting with the corresponding nozzle, the electrodes connected to the heating element, and means for supplying an electric power to the heating element) above mentioned. As shown in Fig. 12, the laser-beam emitting device 60 and the light receiving portion 21b are adapted so that the nozzle 21 with the light receiving portion 21b receives a laser beam irradiated from the laser-beam emitting device 60. In this case, the structure of the supplying container 25 is the same as that in the above embodiment. However, the light receiving portion 21b is formed as a hollow protruding portion that protrudes from a base 24c formed of thermal conduction material on the thermal insulation layer 24b on the body 24a of the nozzle plate 24. The vaporized deposition material is supplied to the nozzle and is held by the nozzle because of the decreased temperature of that protruding portion. When the nozzle 21 is heated by being irradiated with the laser beam, the deposition material held by the nozzle 21 is sublimed, thereby forming a thin film of the deposition material on a substrate arranged to be opposed to the opening of the nozzle. In this embodiment, the fabrication apparatus also includes the power supply 32, the second temperature sensors 33, and the temperature controller 34 as in the structure shown in Fig. 2.

### <Still another embodiment>

Another embodiment of the present invention is described with reference to the drawings.

According to a method for forming a pattern of deposition material of the present embodiment, as shown in Fig. 13, an evaporative deposition-material plate 101 is prepared. The plate 101 includes a light-transmitting plate 101a, that is formed of transparent material such as glass or plastic, for example, in form of disk, and a thin film of the deposition material 101b formed on one principal surface of the light-transmitting plate 101a. The evaporative deposition-material plate 101 is supported in such a manner that the thin film 101b is apart from and opposed to a substrate for display panel 103 on which the pattern is to be formed. Then the plate 101 is moved within a plane parallel to the substrate 103, for example, is rotated around the central axis of the evaporative deposition-material plate 101. In the movement, e.g., rotation of the evaporative deposition-material plate 101, a laser beam 104 is directed to be incident on the other principal surface of the light-transmitting surface 101a so as to cause sublimation and vaporization of the deposition material, thereby depositing a thin film of the deposition material 101c on the substrate 103. When the evaporative deposition-material disk as the evaporative deposition-material plate 101 receives the laser beam on the surface opposite to the surface of the light-transmitting plate having the thin film of deposition material 101b formed thereon, heat generated by the laser beam sublimes and vaporizes the deposition material. The substrate for display panel 103, the evaporative deposition-material disk 101, and the laser-beam emitting device are supported in a vacuum chamber (not shown) having the decreased pressure, of the organic EL display panel fabrication apparatus. The thickness and area of the thin film of deposition material 101c on the substrate 103 are appropriately determined on the basis of a magnifying power with which vaporized gas is expanded, a speed of relative movement of the evaporative deposition-material plate with respect to the substrate, the thickness of the thin film 101b of the deposition material and the like. The above magnifying power is appropriately determined by numerical aperture (NA) related to the laser beam, a power of the laser beam, the speed of the relative movement mentioned above, and the like. According to this embodiment, causing emission of the minimum amount of vapor of the deposition material can form the pattern of the deposition material.

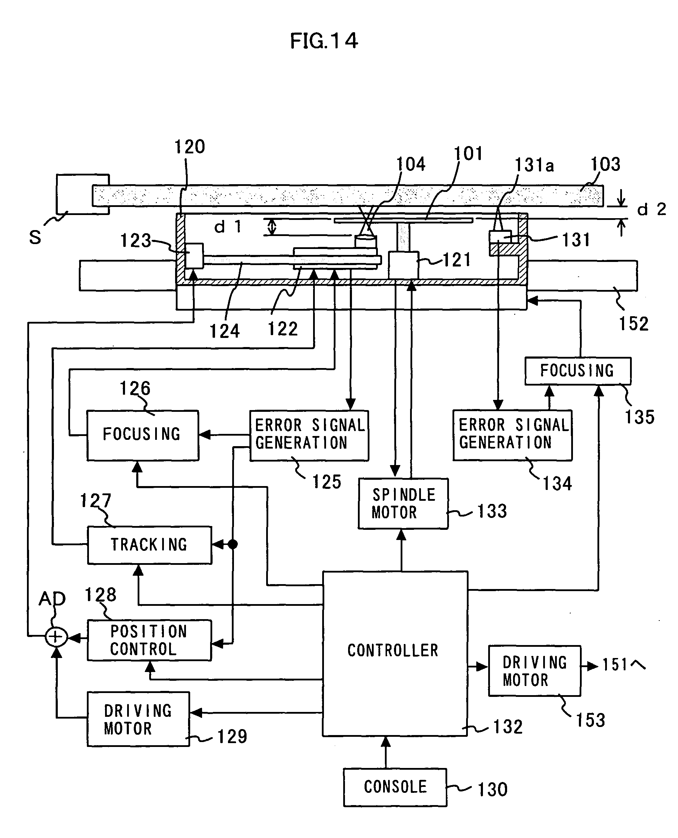

An exemplary application of the method for forming the pattern of the deposition material according to the present invention to a fabrication apparatus of an organic EL display panel, especially to an evaporative deposition apparatus is shown in Fig. 14.

The substrate 103 is placed via a supporting member S in such a manner that a surface thereof on which the pattern is to be formed faces the thin film of the deposition material of the evaporative deposition-material disk 101 on the evaporative deposition apparatus 120, with a space between the substrate 103 and the evaporative deposition-material disk 101. The evaporative deposition apparatus 120 is provided with a spindle motor 121 serving as a supporting mechanism for the evaporative deposition-material disk 101 and a laser-beam emitting device 22 for performing partial heating, which are mounted in the evaporative deposition apparatus 120.

The evaporative deposition-material disk 101 includes: the light-transmitting plate 101a having a diameter of about 12 cm and a thickness of several millimeters, for example, formed of glass or plastic; and a thin film of the deposition material 101b, for example, a light emitting organic compound such as tris(8-quinolinolato) aluminum, formed on one principal surface of the light-transmitting plate 101a by vacuum deposition or evaporative deposition to have a predetermined thickness. The deposition material may be electrode material such as electrically conductive material that can be vaporized and sublimed by being irradiated with laser light.

The evaporative deposition-material disk 101 is mounted on the spindle motor 121 secured to a chassis of the evaporative deposition apparatus 120 and is then driven to rotate by the spindle motor 121. The laser-beam emitting device 22 is provided below the evaporative deposition-material disk 101 in a direction of gravity, and emits a laser beam 104 for heating to the evaporative deposition-material disk 101 to form a laser spot on the thin film of the deposition material, thereby causing vaporization of the thin film of the deposition material partially. The laser-beam emitting device 22 further includes a photodetector that can receive light reflected from the evaporative deposition-material disk 101. From the reflected light, a status is detected. In the evaporative deposition apparatus 120, a feed screw 124 that can be rotated by a motor 123 fixed to the chassis of the evaporative deposition apparatus 120 is provided parallel to the evaporative deposition-material disk 101. The laser-beam emitting device 22 that is screwed together with the feed screw 124 can move along a radial direction of the evaporative deposition-material disk 101.

The photodetector of the laser-beam emitting device 22 is connected to an error signal generating circuit 125, a focusing controlling circuit 126, and a tracking controlling circuit 127.

An electrical signal obtained by photoelectric conversion in a photoelectric conversion device in the laser-beam emitting device 22 that received the reflected light from the evaporative deposition-material disk 101, is input to the error signal generating circuit 125. The error signal generating circuit 125 then generates a focusing error signal and a tracking error signal. The focusing error signal is input to the focusing controlling circuit 126 that drives a focusing actuator (not shown) for an objective lens in the laser-beam emitting device 22. By the focusing actuator, a focusing serve-control is performed for the laser spot, which controls the movement of the objective lens in a direction perpendicular to the principal surface of the evaporative deposition-material disk 101 (i.e. , the distance d1 between the objective lens and the evaporative deposition-material disk).

The tracking error signal is input to the tracking controlling circuit 127 that drives a tracking actuator (not shown) for the objective lens in the laser-beam emitting device 22. By the tracking actuator, fine adjustment of the position of the laser spot in the radial direction of the evaporative deposition-material disk, i.e., a tracking servo-control is performed. The laser-beam emitting device 22 further includes a position controlling circuit 128 to which the tracking error signal is input, which detects a DC component of the tracking error signal and applies a driving signal in accordance with the level of the DC component to the motor 123 via an adder AD. The motor 123 moves the laser-beam emitting device 22 in the radial direction of the evaporative deposition-material disk, thereby roughly adjusting the position of the laser spot in the radial direction of the evaporative deposition-material disk. The tracking control for the laser spot is achieved by the fine adjustment and the rough adjustment mentioned above.

The evaporative deposition apparatus further includes a motor driving circuit 129. A driving output of the motor driving circuit 129 is supplied to the motor 123 serving as the roughly adjusting means via the adder AD. The motor driving circuit 129 is connected to a controller 132 having a console 130, and is controlled by the controller 132. The controller 132 controls operation timings of the focusing controlling circuit 126, the tracking controlling circuit 127, and the position controlling circuit 128.

The spindle motor 121 is connected to a spindle motor controlling circuit 133. The spindle motor 121 is provided with a revolution-speed detector (not shown) for detecting a revolution speed of the spindle motor 121. The spindle motor controlling circuit 133 supplies a driving signal to the spindle motor 121 by using the detected revolution speed of the spindle motor 121, so that the evaporative deposition-material disk 101 is controlled to move at a constant linear velocity by the controller 132. The line width of the pattern formed on the substrate 103 can be adjusted by changing the rotational speed of the evaporative deposition-material disk in accordance with the position of the evaporative deposition-material disk on the substrate through the control by the controller 132.

A laser length measurement unit 131 is fixed to the chassis of the evaporative deposition apparatus 120. The laser length measurement unit 131 emits laser light 131a for length measurement to form a laser spot on the substrate 103, receives light reflected from the substrate 103 and measures a distance between the evaporative deposition apparatus 120 and the substrate 103.

An output of a photoelectric conversion device in the laser length measurement unit 131, that is based on the reflected light from the substrate 103, is input to the second error signal generating circuit 134 which generates the second focusing error signal. The second focusing error signal is input to the second focusing controlling circuit 135. In accordance with thus input focusing error signal, the second focusing controlling circuit 135 drives a gap-adjusting actuator 136 of the evaporative deposition apparatus 120. The gap-adjusting actuator 136 performs a focusing servo-control (movement in the direction perpendicular to the principal surface) which keeps a distance d2 between the evaporative deposition apparatus 120 (evaporative deposition-material disk 101) and the substrate 103 to be a predetermined value.

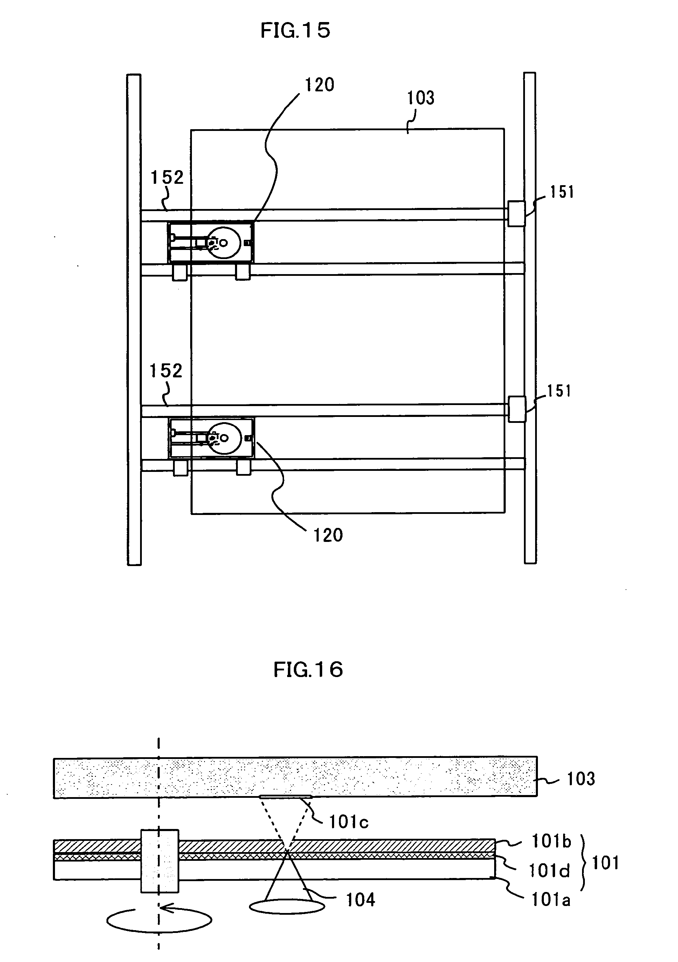

As shown in Fig. 15, the evaporative deposition apparatus 120 includes a translation-driving device that allows translation of the evaporative deposition apparatus 120 with respect to the substrate 103 in a predetermined direction. More specifically, an external feed screw 152 that extends parallel to the substrate 103 and is rotated by an external motor 151 is provided. The feed screw 152 and the chassis of the evaporative deposition apparatus 120 are screwed together. The external motor 151 is connected to the second motor driving circuit 153 (Fig. 14) that is controlled by the controller 132.

The pattern formation of the deposition material can be performed by using a single laser-beam emitting device. However, by using a plurality of sets of the laser-beam emitting device and the evaporative deposition-material disk, the production efficiency can be improved.

A fabrication of a multi-color organic EL display panel is described in which a pattern of the deposition material is formed by the organic EL display panel fabrication apparatus.

First, the substrate 103 on which the pattern is to be formed is placed in the vacuum chamber of the fabrication apparatus (first step).

Then, the evaporative deposition-material disk 101 is placed in such a manner that the thin film of the deposition material of the evaporative deposition-material disk 101 is apart from and opposed to the substrate 103, and is then rotated around the central axis of the evaporative deposition-material disk 101 within a plane parallel to the substrate 103 (second step). During the rotation, the rotational speed of the evaporative deposition-material disk 101 is controlled to allow the laser spot to move at a constant linear velocity with respect to the evaporative deposition-material disk 101. Thus, the pattern having a predetermined width can be deposited. Alternatively, the pattern width can be changed by controlling the rotational speed of the evaporative deposition-material disk 101 so as to allow the linear velocity of the laser spot with respect to the evaporative deposition-material disk to change in accordance with a relative position of the evaporative deposition-material disk with respect to the substrate.

While the other principal surface of the evaporative deposition-material disk is irradiated with the laser beam to form the laser spot on the evaporative deposition-material disk, positioning of the laser spot, i.e, the focusing servo-control, the tracking servo-control and the fine adjustment and rough adjustment of the laser spot in the radial direction of the evaporative deposition-material disk, are performed (third step).

In accordance with the fabrication method of the organic EL display panel mentioned above, a plurality of organic EL devices are arranged on the substrate, each having an organic layer (containing a light emitting layer) sandwiched between a pair of electrodes.

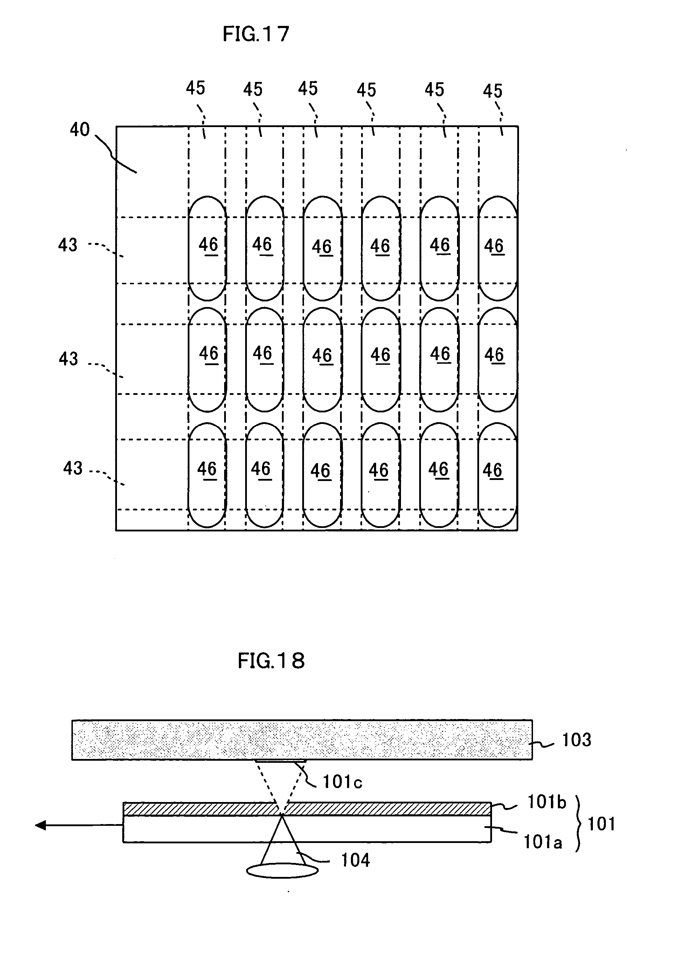

Fig. 17 is a partial plan view of an organic EL display panel 40 having an arrangement of an organic layer 46 formed of an organic compound deposited by the organic EL display panel fabrication apparatus, seen from a transparent-substrate side. For example, the organic layer includes a light emitting layer only, or a hole transport layer, an electron transport layer, an electron injection layer or a hole injection layer in addition to the light emitting layer. In a case where an oval or ellipsoidal pattern of the organic layer 46 is deposited as shown in Fig. 17, a cylindrical lens is provided in an optical system in the laser-beam emitting device 22. On a transparent substrate 103 of the organic EL display panel 40, transparent electrodes 43 formed of indium tin oxide, for example, are deposited in stripes prior to formation of the organic layer 46. The transparent electrodes 43 are arranged in parallel. The pattern of the organic layer is then formed on the transparent electrodes 43 in accordance with the present invention. Then, on the organic layer pattern, metal electrodes 45 that intersect with the transparent electrodes 43 are provided in stripes.

The present invention can be applied to fabrication of an active matrix organic EL display panel in addition to the simple matrix organic EL display panel described above. The active matrix organic EL display panel includes a plurality of active devices such as TFTs formed on a substrate, which are connected to a plurality of organic EL devices, but formed prior to the formation of those organic EL devices. The organic EL display panel 40 can present a full-color image by light-emitting portions 46 (organic EL devices) of red (R), green (G) and blue (B) arranged in a matrix at a predetermined pitch on the transparent substrate 103.

The pattern formation method of the above example uses the evaporative deposition-material disk 101 (see Fig. 13) including the light-transmitting plate 101a and the thin film of the deposition material 101b formed on one principal surface of the light-transmitting plate 101a. Furthermore, as shown in Fig. 16, the pattern of the deposition material can be deposited by using an evaporative deposition-material disk including the light-transmitting plate 101a, a photo-thermal conversion layer 101d formed on one principal surface of the light-transmitting plate 101a and the thin film of deposition material 101b formed on the photo-thermal conversion layer 101d. Due to the photo-thermal conversion layer 101d between the light-transmitting plate 101a and the thin film of the deposition material 101b, the magnifying power with which emission of vaporized or sublimed deposition material expands can be adjusted.

In addition, the present invention may use the straight movement of the evaporative deposition-material plate and the substrate instead of using the rotation of the evaporative deposition-material disk. As shown in Fig. 18, the evaporative deposition-material plate 101 including the light-transmitting plate 101a and the thin film of the deposition material 101b, that is in form of strip such as a tape, a sheet or a card, may be used. In this case, the same effects as those mentioned above can be obtained by irradiating the evaporative deposition-material plate 101 with a laser beam from the light-transmitting plate side while the evaporative deposition-material plate 101 is translated with respect to the substrate 103 within a plane parallel to the substrate 103.

## Claims

1. A evaporative deposition method comprising the steps of:
supplying a vaporized deposition material to a nozzle;
holding the deposition material at the nozzle by lowering a temperature thereof; and
vaporizing the deposition material by heating the nozzle to eject a secondary vaporized deposition material from the nozzle to form a thin film of the deposition material on a substrate arranged to be opposed to the nozzle.

2. The evaporative deposition method according to claim 1, wherein the nozzle is connected to a thermal conduction element to accelerate cooling of the nozzle.

3. The evaporative deposition method according to claim 2, wherein the nozzle is connected to a supply side of the vaporized deposition material by a thermal insulation element.

4. The evaporative deposition method according to any one of claims 1-3, wherein the heating of the nozzle is achieved by supplying an electric power to electrodes connected to a heating element that is in contact with the nozzle.

5. The evaporative deposition method according to any one of claims 1-3, wherein the nozzle is heated by being irradiated with a laser beam.

6. The evaporative deposition method according to any one of claims 1-5, wherein a plurality of the nozzles are provided and temperatures of the nozzles are controlled independently.

7. The evaporative deposition method according to claim 6, wherein the nozzles are selectively heated.

8. The evaporative deposition method according to any one of claims 1-7, wherein translation of one of the nozzle and the substrate with respect to the other is performed intermittently.

9. A evaporative deposition head comprising:
a nozzle for holding a deposition material, the nozzle having an opening through which the deposition material to be vaporized is ejected;
a temperature adjuster for heating and cooling the nozzle; and
a supplier, communicating with the nozzle, for supplying the deposition material to be vaporized to the nozzle.

10. The evaporative deposition head according to claim 9, further comprising a thermal conduction element connected to the nozzle.

11. The evaporative deposition head according to claim 10, further comprising a thermal insulation element provided between the nozzle and the supplier.

12. The evaporative deposition head according to any one of claims 9-11, wherein the temperature adjuster includes a heating element that is in contact with the nozzle, and electrodes connected to the heating element, an electric power being supplied to the electrodes.

13. The evaporative deposition head according to any one of claims 9-11, wherein the temperature adjuster includes a light receiving portion, provided to be in contact with the nozzle, for receiving a laser beam.

14. The evaporative deposition head according to any one of claims 9-13, wherein a plurality of the nozzles are provided, and the temperature adjuster heats the nozzles individually.

15. The evaporative deposition head according to claim 14, wherein the temperature adjuster is connected to a controller for selecting one of the nozzles that is to be heated.

16. The evaporative deposition head according to any one of claims 9-15, wherein the evaporative deposition head is connected to a driving device for causing a relative translation of one of the nozzle and the substrate with respect to the other intermittently.

17. A fabrication apparatus for producing an organic electroluminescence display panel which includes a plurality of organic electroluminescence devices arranged on a substrate, each of organic electroluminescence devices having at least one organic layer that is sandwiched between a pair of electrodes and contains a light emitting layer, the fabrication apparatus comprising:
an evaporative deposition head including
a plurality of nozzles for holding a deposition material for the organic electroluminescence devices,
a temperature adjuster for heating and cooling the nozzles, and
a supplier, communicating with the nozzles, for supplying the deposition material to be vaporized to the nozzles, the nozzles having openings through which the deposition material to be vaporized is ejected; and
a supporting mechanism for supporting the evaporative deposition head in such a manner that the openings of the nozzles are opposed to the substrate with a space therebetween.

18. The fabrication apparatus according to claim 17, wherein the evaporative deposition head includes a thermal conduction element, attached to the nozzles, for accelerating cooling.

19. The fabrication apparatus according to claim 18, wherein the evaporative deposition head includes a thermal insulation element provided between the thermal conduction element and the supplier.

20. The fabrication apparatus according to any one of claims 17-19, wherein the temperature adjuster includes heating elements that are in contact with the nozzles and electrodes connected to the heating elements, an electric power being supplied to the electrodes.

21. The fabrication apparatus according to anyone of claims 17-20, wherein the temperature adjuster heats the nozzles individually by the heating elements.

22. The fabrication apparatus according to claim 21, further comprising a controller, connected to the temperature adjuster, for selecting one of the nozzles that is to be heated.

23. The fabrication apparatus according to any one of claims 17-21, further comprising a driving device, connected to the evaporative deposition head, for causing a relative translation of one of the substrate and the nozzles with respect to the other intermittently.

24. The fabrication apparatus according to anyone of claims 17-23, wherein a plurality of sets of the nozzle and the heating element are arranged one-dimensionally.

25. The fabrication apparatus according to any one of claims 17-23, wherein a plurality of sets of the nozzle and the heating element are arranged two-dimensionally.

26. The fabrication apparatus according to any one of claims 17-25, wherein the temperature adjuster includes a temperature detector, connected to the nozzles or heating elements, for detecting a temperature, and a temperature controller, connected to the temperature detector, for controlling temperatures of the nozzles or heating element in accordance with the detected temperature.

27. The fabrication apparatus according to any one of claims 17-26, wherein the evaporative deposition head is arranged below the substrate in a direction of gravity.

28. A method for forming a pattern of deposition material, comprising the steps of:
preparing an evaporative deposition-material plate including a light-transmitting plate and a thin film of a deposition material formed on one principal surface of the light-transmitting plate;
moving the evaporative deposition-material plate within a plane parallel to a substrate that is arranged to be opposed to the thin film with a space therebetween; and
irradiating the light-transmitting plate with a laser beam from the other principal surface of the light-transmitting plate, to vaporize and eject the deposition material to deposit the vaporized deposition material on the substrate.

29. The method for forming a pattern of deposition material according to claim 28, wherein a shape of the evaporative deposition-material plate is a disk, and the evaporative deposition-material plate is rotated around a central axis of the disk.

30. The method for forming a pattern of deposition material according to claim 28, wherein a shape of the evaporative deposition-material plate is a strip, and the evaporative deposition-material plate is translated.

31. A evaporative deposition-material disk comprising a light-transmitting plate; and a thin film of a deposition material formed on one principal surface of the light-transmitting plate, wherein the evaporative deposition-material disk is irradiated with a laser beam incident on the other principal surface of the light-transmitting plate.

32. A evaporative deposition-material disk comprising a light-transmitting plate; a photo-thermal conversion layer formed on one principal surface of the light-transmitting plate; and a thin film of a deposition material formed on the photo-thermal conversion layer, wherein the evaporative deposition-material disk is irradiated with a laser beam incident on another surface of the light-transmitting plate.

33. A fabrication apparatus of an organic electroluminescence display panel including a plurality of organic electroluminescence devices each having at least one organic layer that is sandwiched between a pair of electrodes and contains a light emitting layer, the fabrication apparatus comprising:
a laser-beam emitting device for emitting a laser beam;
an evaporative deposition-material disk including a light-transmitting plate, a thin film of a deposition material formed on one principal surface of the light-transmitting plate, the evaporative deposition-material disk being irradiated with the laser beam incident on another surface of the light-transmitting plate; and
a supporting mechanism for supporting the evaporative deposition-material disk in such a manner that the thin film is apart from a substrate and is opposed to the substrate, and to rotate the evaporative deposition-material disk around a central axis of the evaporative deposition-material disk within a plane parallel to the substrate.

34. The fabrication apparatus according to claim 33, wherein at least one active device connected to the organic electroluminescence device is formed on the substrate.

35. The fabrication apparatus according to claim 33 or 34, wherein the laser-emitting device is arranged below the substrate in a direction of gravity.

36. The fabrication apparatus according to any one of claims 33-35, further comprising a translation driving device for causing a translation of one of the laser-emitting device and the substrate with respect to the other.

37. The fabrication apparatus according to any one of claims 33-36 , wherein a plurality of the laser-emitting devices are provided.

38. The fabrication apparatus according to any one of claims 33-37, wherein the deposition material is an organic material or an electrode material.

39. A fabrication method of an organic electroluminescence display panel including a plurality of organic electroluminescence devices each having at least one organic layer that is sandwiched between a pair of electrodes and contains a light emitting layer, the fabrication method comprising:
a first step of fixedly arranging a substrate on which a pattern is to be formed;
a second step of arranging an evaporative deposition-material disk including a light-transmitting plate and a thin film of a deposition material formed on one principal surface of the light-transmitting plate in such a manner that the thin film is apart from the substrate and is opposed to the substrate, and rotating the evaporative deposition-material disk around a central axis of the evaporative deposition-material disk within a plane parallel to the substrate;
a third step of irradiating the other principal surface of the evaporative deposition-material disk with a laser beam to form a laser spot and positioning the laser spot on the thin film; and
a fourth step of positioning the evaporative deposition-material disk with respect to the substrate, wherein the deposition material is deposited on the substrate by vaporizing the deposition material.

40. The fabrication method according to claim 39, wherein the third step includes a step of moving the laser spot in a radial direction of the evaporative deposition-material disk.

41. The fabrication method according to claim 39 or 40, wherein the third step includes a step of performing focusing-servo control for the laser spot.

42. The fabrication method according to any one of claims 39-41, wherein the second step includes a step of controlling a rotational speed of the evaporative deposition-material disk in such a manner that the laser spot moves at a constant liner velocity with respect to the evaporative deposition-material disk.

43. The fabrication method according to any one of claims 39-41, wherein the second step includes a step of controlling a rotational speed of the evaporative deposition-material disk in such a manner that a linear velocity of the laser spot with respect to the evaporative deposition-material disk changes in accordance with a relative position of the evaporative deposition-material disk to the substrate.

44. The fabrication method according to any one of claims 39-43, wherein the fourth step includes a step of relatively translating one of the evaporative deposition-material disk and the substrate with respect to the other.

45. The fabrication method according to any one of claims 39-44, wherein the laser beam is emitted from a position under the substrate in a direction of gravity.

46. The fabrication method according to any one of claims 39-45, wherein the deposition material is an organic material or an electrode material.
